# EUROPEAN PATENT SPECIFICATION

(11) **EP 3 108 543 B1**
(45) Date of publication and mention of the grant of the patent: **25.03.2020**
(21) Application number: 15752878.7
(22) Date of filing: 20.02.2015
(51) Int. Cl.: H01R 13/03, H01R 13/6594, H01R 13/6598, H01R 24/50, H05K 9/00, H01R 103/00

(54) **HIGH ISOLATION GROUNDING DEVICE**
ERDUNGSVORRICHTUNG MIT HOHER ISOLIERUNG
DISPOSITIF DE MISE À LA MASSE À HAUTE ISOLATION

(30) Priority: 23.02.2014 US 201461966482 P
(43) Date of publication of application: 28.12.2016
(73) Proprietor: Cinch Connectivity Solutions, Inc., Bannockburn, Illinois 60015 (US)
(72) Inventor: BAUMLER, Robert, Waseca, Minnesota 56093 (US); DVORAK, Mark, Waseca, Minnesota 56093 (US); KEREKES, James, Waterville, Minnesota 56096 (US)
(74) Representative: Wilkinson, Stephen John
(86) International application number: PCT/US2015/016807
(87) International publication number: WO 2015/127196

(56) References cited:
- JP-A- H08 153 986
- JP-A- 2006 100 521
- JP-B2- 4 246 682
- JP-B2- 4 984 896
- KR-B1- 101 055 492
- US-A- 6 037 846
- US-A1- 2007 049 082
- US-A1- 2010 124 854

## Description

### BACKGROUND OF THE INVENTION

### 1. Field of the Invention

The invention concerns an EMI gasket which is mountable to a printed circuit board (PCB) and which is also engageable with a connector which reduces electromagnetic interference (EMI).

### 2. Discussion of the Background

Devices such as a gasket which is made of an elastomeric material which is impregnated with conductive material are known. Also, electrical connectors which operate in the RF spectrum are known. Typically, the gasket is mounted between the printed circuit board and the electrical connector so as to reduce the amount of electromagnetic radiation which potentially could escape somewhere between the surface of the PCB and the electrical connector. As the number of transmitted electrical signals increases the number of electrical connectors increases. However, in some applications, the amount of space available to accommodate the electrical connectors has not increased. Thus, the density per unit space of connectors is increased. The density can be increased, but the increase in density is limited by how closely the port of one coaxial conductor can be placed adjacent to the port of another coaxial conductor without there being an unacceptable amount of crosstalk or leakage of electromagnetic radiation from one port to another port. The amount of leakage becomes unacceptable when the signal being transported by one of the coaxial conductors is corrupted by the electromagnetic radiation emitted by the other coaxial conductor.

Also known in the art are ganged connectors, such as the connector disclosed in U.S. Patent No. 7,927,125. This connector has a predefined number of electrical ports that can be accommodated. If the number of desired ports exceeds the number of ports provided on the connector, then another connector must be used or a special connector must be made. JP 2006100521A discloses a gasket for electromagnetic wave shielding. This gasket has a cushion formed by coating the surface of an elliptical sectional foamed material with a conductive cloth.

### SUMMARY OF THE INVENTION

The invention relates to an EMI gasket according to claim 1, said gasket being mountable to a printed circuit board and engageable with a ganged connector which reduces the amount of electromagnetic radiation emitted between ports of the ganged electrical connector when the ganged electrical connector is connected to a printed circuit board.

According to the invention, there is provided an EMI gasket mountable to a printed circuit board and engageable with a ganged connector, the printed circuit board having a surface and the ganged connector having a boss with a tapered outer wall, the gasket comprising a body and a plurality of ports comprising a plurality of contact portions in electrical association with the body, the contact portions each having an inner wall defining an inside diameter (ID1), the body and the contact portions including a conductive material,
characterised in that the body is a planar body, the planar body being configured and dimensioned such that when the planar body is mounted on the printed circuit board no air pockets are formed or exist between the planar body and the printed circuit board, the inner wall of one of the ports is configured to contact the tapered outer wall of the boss when the ganged connector is introduced toward the printed circuit board so that the gasket is in electrical communication with the boss and an amount of electromagnetic radiation emitted between ports is reduced when the ganged connector is connected to the printed circuit board, the contact portions having an annular shape extending from the planar body so that a portion of each contact portion is deformable, when the ganged connector is urged toward the printed circuit board.

In certain embodiments, each contact portion may include at least one slot.

In certain embodiments, each contact portion may include at least one triangular-shaped section.

Each contact portion has an inside diameter (ID1) and an overall thickness (T1), and the body has an overall thickness (T2).

In certain embodiments, the overall thickness (T2) of the body may be greater than the overall thickness (T1) of each contact portion.

In another aspect of the present disclosure, an EMI gasket is disclosed that includes a planar body having an overall thickness (T2), and a plurality of contact portions in electrical association with the body so as to form ports, wherein each contact portion has an overall thickness (T1).

The body and the plurality of contact portions include a conductive material, e.g., aluminium, beryllium copper, or combinations thereof.

In certain embodiments, the overall thickness (T2) of the body may be greater than the overall thickness (T1) of each contact portion, whereas in certain other embodiments, the overall thickness (T2) of the body may be equal to the overall thickness (T1) of each contact portion.

The disclosed gasket includes a planar body, and a plurality of contact portions in electrical association with the body so as to form ports, wherein each contact portion has an inner wall defining an inside diameter (ID1).

The body and plurality of contact portions include a conductive material, e.g., aluminium, beryllium copper, or combinations thereof.

The gasket is configured and dimensioned such that, when mounted on the printed circuit board, no air pockets are formed or exist between the gasket and the printed circuit board.

The ganged connector is configured and dimensioned such that when the ganged connector is introduced toward the printed circuit board, the at least one boss of the ganged connector is introduced into contact with one of the plurality of contact portions. The ganged connector is further configured and dimensioned such that when the ganged connector is introduced into contact with the printed circuit board, the tapered outer wall of the boss contacts the inner wall of one of the ports so that the boss is in electrical communication with the gasket.

The gasket has a height which is less than a distance measured between the surface of the printed circuit board and a surface on the ganged connector from which the boss originates.

In certain embodiments, each contact portion may include at least one slot.

In certain embodiments, each contact portion may include at least one triangular-shaped section.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Figure 1 is a perspective view of a first embodiment of the gasket of the invention;
Figure 2 is a partial cross-sectional side view of the gasket of Figure 1, taken along section line 2-2, mounted between a ganged connector and a printed circuit board;
Figure 3 is the partial cross-sectional side view of Figure 2, minus the conductors and insulative spacers, which identifies more details of the gasket of Figure 1;
Figure 4 is a partial cross-sectional side view of the ganged connector of Figure 2;
Figure 5 is a partial cross-sectional side view of the gasket of the invention as taken from Figure 2;
Figure 6 is a perspective view of a second embodiment of the invention;
Figure 7 is a partial perspective view of the second embodiment of the invention as it engages the ganged connector;
Figure 8 is a perspective view of a third embodiment of the invention; and
Figure 9 is a partial perspective view of the third embodiment of the invention as it engages the ganged connector.

### DETAILED DESCRIPTION OF THE PRESENTLY PREFERRED EMBODIMENTS

Referring now to the drawings, wherein like reference numerals designate identical or corresponding parts through the several views, embodiments of the present invention are displayed therein.

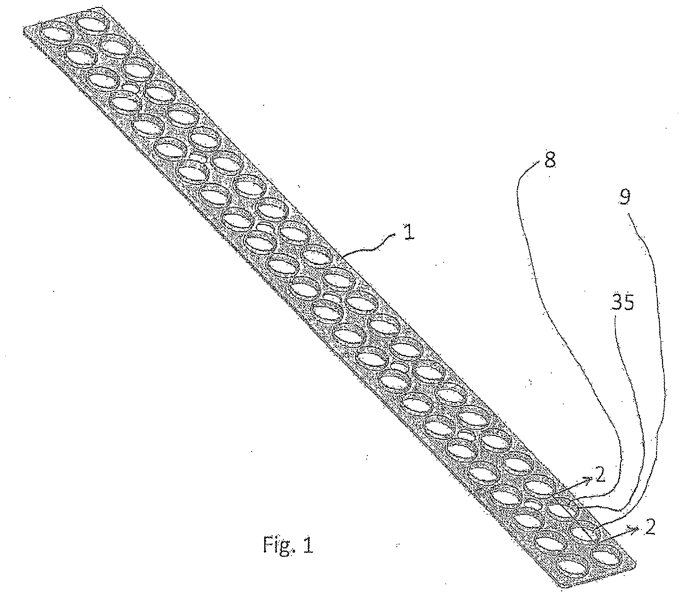

Figure 1 is a perspective view of the first embodiment of the EMI gasket 1. The EMI gasket 1 contains forty-eight ports which are arranged in two rows where each row contains twenty-four ports. A first port 8 and a second port 9 are identified. The EMI gasket 1 is constructed of a conductive metallic material such as aluminium or beryllium copper. The EMI gasket 1 includes a contact portion 35 which is shown in conjunction with port 8, but note that each port includes a contact portion. The contact portion 35 can be machined integral with the remainder of the EMI gasket 1 or the contact portions 35 can be joined to the remainder of the EMI gasket by way of welding, brazing, or other joining techniques well known in the art. The contact portion 35 is shown to have a shape of a ring or annulus.

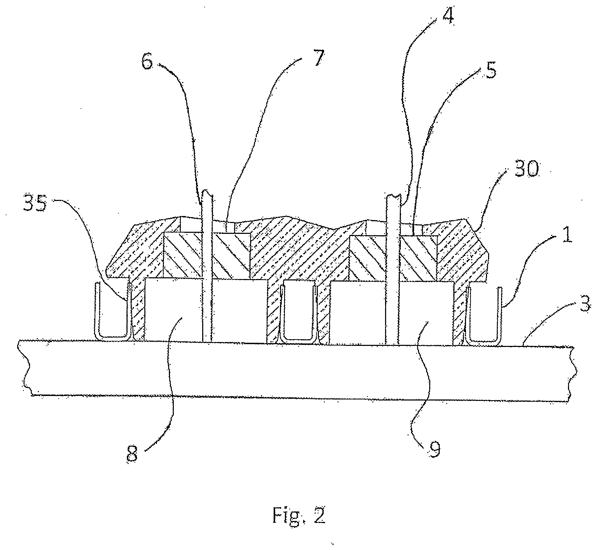

Figure 2 is a partial cross-sectional side view of the first embodiment of the invention, taken along section line 2-2 of Figure 1, where the EMI gasket 1 is soldered to a printed circuit board 3. The EMI gasket 1 is soldered to the printed circuit board 3 so that no air pockets are formed or exist between the EMI gasket 1 and the printed circuit board 3. The EMI gasket 1 is also shown engaged with a ganged connector 30. Further shown are a conductor 6 positioned in port 8, where the conductor 6 is separated from the conductive body of the ganged connector 30 by an insulative spacer 7. Still further shown are a conductor 4 positioned in port 9, where the conductor 4 is separated from the conductive body of the ganged connector 30 by an insulative spacer 5. The engagement of the EMI gasket 1 with the printed circuit board 3 and with the ganged connector 30 prevents an unacceptable level of electromagnetic radiation from entering one port from another port. Thus the signals being carried by conductors 4 and 6 are not corrupted. For reasons of clarity, the EMI gasket 1 is not shown as being cross-hatched, even though the component is section, since the EMI gasket 1 is relatively thin as compared to the other components.

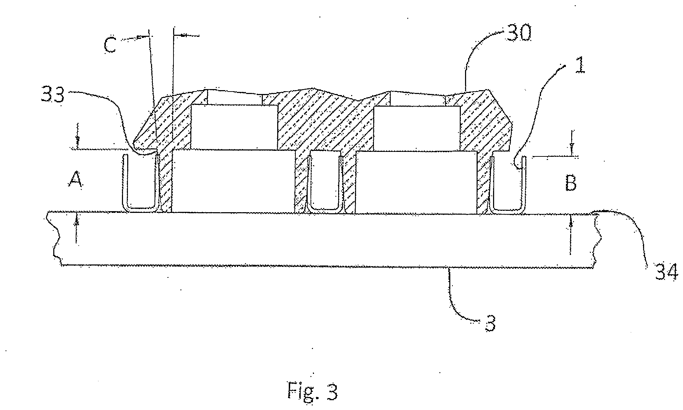

Figure 3 is the partial cross-sectional side view of Figure 2 without conductors 4, 6 and insulative spacers 5, 7 being shown for reasons of clarity. A boss 33 is shown as projecting from the body of the ganged connector 30. The boss 33 generally has a ring or annular shape. The boss 33 of the ganged connector 30 is shown in contact with a surface 34 of the printed circuit board 3. A boss is associated with each port. The outside diameter of the boss 33 is shown to have a draft angle C. A distance A identifies the distance from the surface 34 of the printed circuit board 3 to a surface from which the boss 33 originates out of the body of the ganged connector 30 when the boss 33 contacts the surface 34 of the printed circuit board 3. A distance B identifies a height of the EMI gasket 1. Note that distance A is greater than distance B.

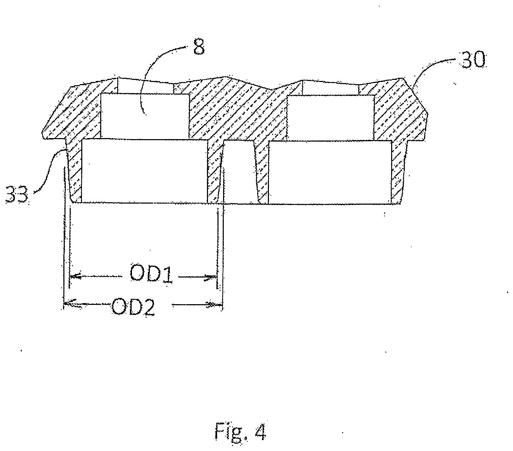

Figure 4 is a partial cross-sectional side view of the ganged connector 30 including boss 33. Identified in Figure 4 are an outside diameter OD1 of the boss 33 and an outside diameter OD2 of the boss 33 which are associated with port 8. Note that outside diameter OD2 is greater than outside diameter OD1.

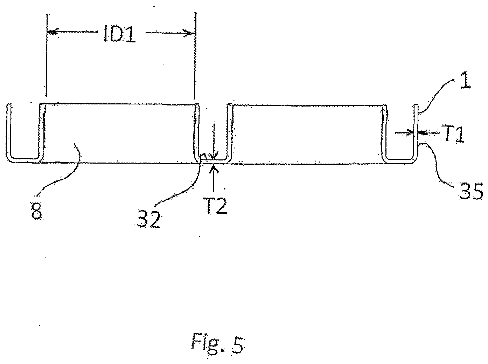

Figure 5 is a partial cross-sectional side view of the EMI gasket 1. The contact portion 35 of the EMI gasket 1 includes an inside diameter ID1 associated with port 8. The contact portion 35 has a thickness T1 and the remainder or body 32 of the EMI gasket 1 has a thickness T2. The inside diameter ID1 of the EMI gasket 1 is greater than the outside diameter OD1 of the boss 33 so that the boss 33 can enter the contact portion 35 of the EMI gasket 1. The inside diameter ID1 is less than the outside diameter OD2 of boss 33. So, when the boss 33 is further introduced into the contact portion 35, the outside diameter of the boss 33 engages the contact portion 35, and when the boss 33 and hence the ganged connector 30 are further urged toward the printed circuit board 3 so that the boss 33 contacts the surface 34 of the printed circuit board 3, then a portion of the contact portion 35 is deformed to a larger diameter. Preferably the deformation is elastic. As compared to the contact portion 35, the boss 33 is substantially rigid. When the boss 33 contacts the contact portion 35, then the ganged connector 30 is in electrical communication with the EMI gasket 1, and thus the components are grounded to each other. Thickness Ti is shown as being substantially the same as thickness T2.

However, note that thickness T1 need not be substantially the same as T2. Additionally, dimension B which identifies the height of the EMI gasket 1 can be substantially different than as shown in Figure 2. If the deformation is elastic, then the gang connector 30 can be mounted and de-mounted to the EMI gasket 1 more than once. Additionally, it has been found that adequate isolation can be achieved even if the boss 33 does not contact the surface 34 of the printed circuit board 3, but it must be close. However, it is preferable that the boss 33 does contact the surface 34 of the printed circuit board 3.

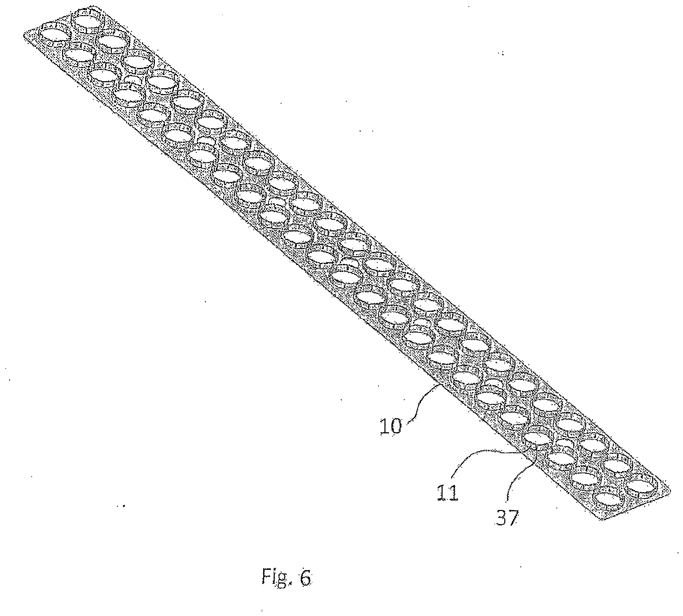

Figure 6 is a perspective view of a second embodiment of the invention which is an EMI gasket 10 having a contact portion 11 which includes slots 37 in the contact portion 11. Otherwise, EMI gasket 10 is substantially similar to EMI gasket 1.

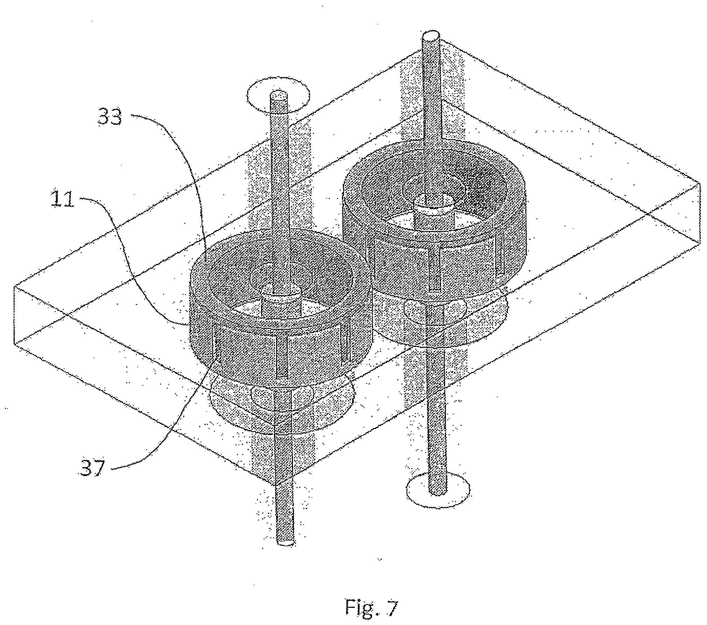

Figure 7 is a partial perspective view of the contact portion 11, including the slots 37, of EMI gasket 10 engaged with boss 33. The slotted contact portion 11 allows for more flexibility of the contact portion 11 as compared to the contact portion 35 that does not include slots, yet the EMI gasket 10 still provides for adequate reduction of electromagnetic interference between adjacent ports of the ganged connector 30.

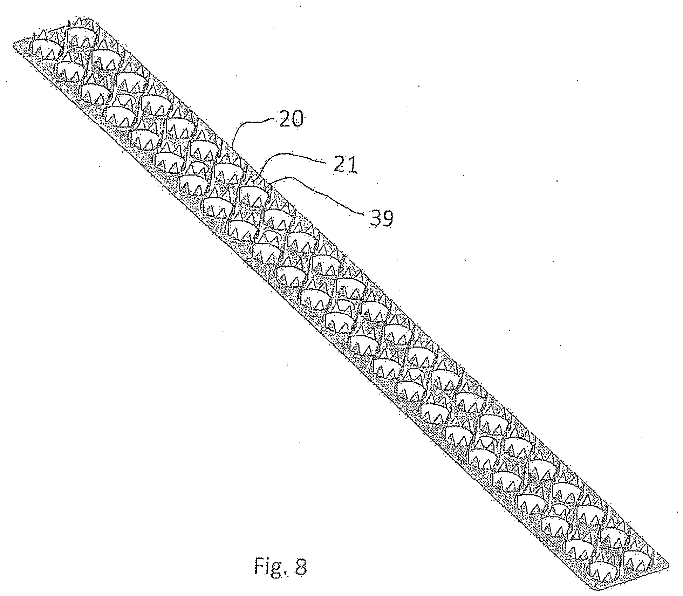

Figure 8 is a perspective view of a third embodiment of the invention which is an EMI gasket 20 having a contact portion 39 which includes triangular-shaped sections 21. Otherwise, EMI gasket 20 is substantially similar to EMI gasket 1.

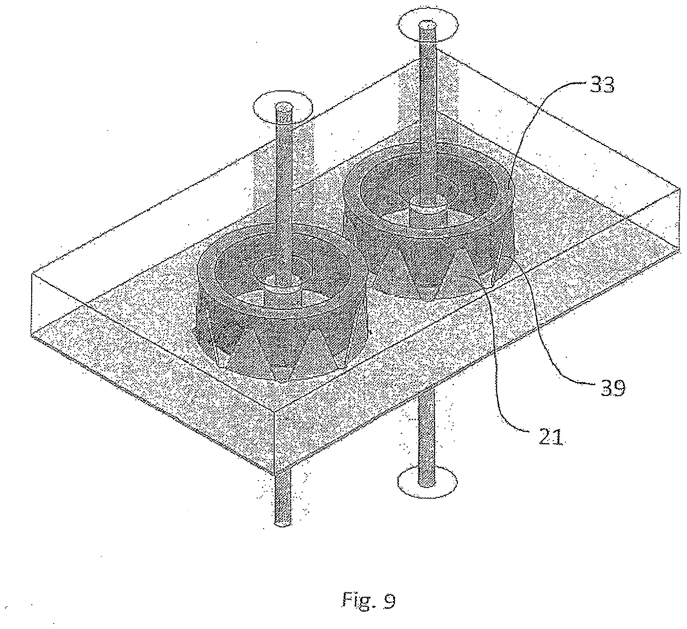

Figure 9 is a partial perspective view of the contact portion 39, including the triangular-shaped sections 21, of EMI gasket 20 engaged with boss 33. The contact portion 39, including the triangular-shaped sections 21, allows for more flexibility of the contact portion 39 as compared to the contact portion 35 that does not include triangular-shaped sections, yet the EMI gasket 20 still provides for adequate reduction of electromagnetic interference between adjacent ports of the ganged connector 30.

## Claims

1. An EMI gasket (20) mountable to a printed circuit board (3) and engageable with a ganged connector (30), the printed circuit board (3) having a surface (34) and the ganged connector (30) having a boss (33) with a tapered outer wall, the gasket (20) comprising a body and a plurality of ports (8, 9) comprising a plurality of contact portions (35, 39) in electrical association with the body, the contact portions (35, 39) each having an inner wall defining an inside diameter (ID1), the body and the contact portions (35, 39) including a conductive material,
**characterised in that** the body is a planar body, the planar body being configured and dimensioned such that when the planar body is mounted on the printed circuit board (3) no air pockets are formed or exist between the planar body and the printed circuit board (3), the inner wall of one of the ports (8, 9) is configured to contact the tapered outer wall of the boss (33) when the ganged connector (30) is introduced toward the printed circuit board (3) so that the gasket (20) is in electrical communication with the boss (33) and an amount of electromagnetic radiation emitted between ports is reduced when the ganged connector (30) is connected to the printed circuit board (3), the contact portions (35, 39) having an annular shape extending from the planar body so that a portion of each contact portion (35, 39) is deformable, when the ganged connector (30) is urged toward the printed circuit board (3).

2. The EMI gasket according to claim 1, wherein the body and the contact portions (35, 39) include aluminium.

3. The EMI gasket according to claim 1, wherein the body and the contact portions (35, 39) include beryllium copper.

4. The EMI gasket according to any one of claims 1 to 3, wherein each of the contact portions (35, 39) includes at least one slot (37).

5. The EMI gasket according to any one of claims 1 to 3, wherein each of the contact portions (35, 39) includes a triangular-shaped section (21) that extends in a direction away from the planar body.

## Patentansprüche

1. EMV-Dichtung (20), die an einer Leiterplatte (3) montiert und mit einem Mehrfachstecker (30) in Eingriff gebracht werden kann, wobei die Leiterplatte (3) eine Oberfläche (34) aufweist und der Mehrfachstecker (30) einen Ansatz (33) mit einer konisch zulaufenden Außenwand aufweist, die Dichtung (20) einen Körper und eine Vielzahl von Anschlüssen (8, 9) mit einer Vielzahl von Kontaktabschnitten (35, 39) in elektrischer Verbindung mit dem Körper umfasst, die Kontaktabschnitte (35, 39) jeweils eine Innenwand aufweisen, die einen Innendurchmesser (ID1) definiert, und der Körper und die Kontaktabschnitte (35, 39) ein leitfähiges Material aufweisen,
**dadurch gekennzeichnet, dass** der Körper ein ebener Körper ist, der ebene Körper dafür ausgelegt und bemessen ist, dass, wenn der ebene Körper auf der Leiterplatte (3) montiert ist, keine Lufteinschlüsse zwischen dem ebenen Körper und der Leiterplatte (3) gebildet werden oder bestehen, die Innenwand eines der Anschlüsse (8, 9) dafür ausgelegt ist, dass sie die konisch zulaufende Außenwand des Ansatzes (33) berührt, wenn der Mehrfachstecker (30) in Richtung der Leiterplatte (3) eingeführt wird, so dass die Dichtung (20) in elektrischer Kommunikation mit dem Ansatz (33) ist und eine Menge von elektromagnetischer Strahlung, die zwischen Anschlüssen emittiert wird, reduziert wird, wenn der Mehrfachstecker (30) mit der Leiterplatte (3) verbunden ist, die Kontaktabschnitte (35, 39) eine Ringform aufweisen, die sich so vom ebenen Körper erstreckt, dass ein Abschnitt jedes Kontaktabschnitts (35, 39) verformbar ist, wenn der Mehrfachstecker (30) in Richtung der Leiterplatte (3) gedrückt wird.

2. EMV-Dichtung nach Anspruch 1, wobei der Körper und die Kontaktabschnitte (35, 39) Aluminium aufweisen.

3. EMV-Dichtung nach Anspruch 1, wobei der Körper und die Kontaktabschnitte (35, 39) Berylliumkupfer aufweisen.

4. EMV-Dichtung nach einem der Ansprüche 1 bis 3, wobei jeder der Kontaktabschnitte (35, 39) mindestens einen Schlitz (37) aufweist.

5. EMV-Dichtung nach einem der Ansprüche 1 bis 3, wobei jeder der Kontaktabschnitte (35, 39) ein dreieckförmiges Teilstück (21) aufweist, das sich in einer Richtung vom ebenen Körper weg erstreckt.

## Revendications

1. Joint IEM (20) pouvant être monté sur un circuit imprimé (3) et pouvant entrer en prise avec un connecteur accouplé (30), le circuit imprimé (3) comportant une surface (34) et le connecteur accouplé (30) comportant une protubérance (33) avec une paroi externe conique, le joint (20) comprenant un corps et une pluralité d'orifices (8, 9) comprenant une pluralité de parties de contact (35, 39) en association électrique avec le corps, les parties de contact (35, 39) comportant chacune une paroi interne définissant un diamètre intérieur (ID1), le corps et les parties de contact (35, 39) comprenant un matériau conducteur,
**caractérisé en ce que** le corps est un corps plan, le corps plan étant conçu et dimensionné de telle sorte que, lorsque le corps plan est monté sur le circuit imprimé (3), aucune poche d'air n'est formée ou n'existe entre le corps plan et le circuit imprimé (3), la paroi interne de l'un des orifices (8, 9) est conçu pour entrer en contact avec la paroi externe conique de la protubérance (33) lorsque le connecteur accouplé (30) est introduit en direction du circuit imprimé (3) de telle sorte que le joint (20) est en communication électrique avec la protubérance (33) et une quantité de rayonnement électromagnétique émis entre les orifices est réduite lorsque le connecteur accouplé (30) est connecté au circuit imprimé (3), les parties de contact (35, 39) étant de forme annulaire s'étendant depuis le corps plan, de telle sorte qu'une partie de chaque partie de contact (35, 39) peut se déformer lorsque le connecteur accouplé (30) est poussé en direction du circuit imprimé (3).

2. Joint IEM selon la revendication 1, dans lequel le corps et les parties de contact (35, 39) comprennent de l'aluminium.

3. Joint IEM selon la revendication 1, dans lequel le corps et les parties de contact (35, 39) comprennent du cuivre au béryllium.

4. Joint IEM selon l'une quelconque des revendications 1 à 3, dans lequel chacune des parties de contact (35, 39) comprend au moins une fente (37).

5. Joint IEM selon l'une quelconque des revendications 1 à 3, dans lequel chacune des parties de contact (35, 39) comprend une section triangulaire (21) qui s'étend dans une direction opposée au corps plan.
